(19) Europäisches Patentamt
European Patent Office
Office européen des brevets

(11) **EP 2 746 790 B1**

(12) **EUROPEAN PATENT SPECIFICATION**

(45) Date of publication and mention
of the grant of the patent:
**04.12.2019 Bulletin 2019/49**

(51) Int Cl.:
**G01R 31/02** *(2006.01)*     **G01R 31/06** *(2006.01)*

(21) Application number: **13460073.3**

(22) Date of filing: **13.11.2013**

(54) **Method and circuit for measuring own and mutual thermal resistances of a magnetic device**

Verfahren und Schaltung zur Messung eigener und gemeinsamer thermischer Widerstände einer magnetischen Vorrichtung

Procédé et circuit pour mesurer des résistances thermiques individuelles et mutuelles d'un dispositif magnétique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.12.2012 PL 40222312**
**12.07.2013 PL 40466813**

(43) Date of publication of application:
**25.06.2014 Bulletin 2014/26**

(73) Proprietor: **Uniwersytet Morski w Gdyni**
**81-225 Gdynia (PL)**

(72) Inventors:
• **Górecki, Krzysztof**
**84-230 Rumia (PL)**
• **Zarebski, Janusz**
**80-292 Gdansk (PL)**
• **Detka, Kalina**
**81-052 Gdynia (PL)**
• **Rogalska, Malgorzata**
**83-110 Tczew (PL)**

(74) Representative: **Czabajski, Jacek**
**TRASET**
**Rzecznicy Patentowi Sp.p**
**Ul. Piecewska 27**
**80-288 Gdansk (PL)**

(56) References cited:
**WO-A1-2009/026038      DD-A1- 240 461**
**JP-A- H0 735 813**

• **SON K T ET AL: "Temperature measurement of high-density winding coils of electromagnets", IET SCIENCE, MEASUREMENT AND TECHNOLOGY, THE INSTITUTION OF ENGINEERING AND TECHNOLOGY, MICHAEL FARADAY HOUSE, SIX HILLS WAY, STEVENAGE, HERTS. SG1 2AY, UK, vol. 6, no. 1, 3 January 2012 (2012-01-03) , pages 1-5, XP006041220, ISSN: 1751-8822, DOI: 10.1049/IET-SMT.2011.0133**

**Description**

The presented invention relates to a method and system for measuring own and mutual thermal resistances of a magnetic device, such as a transformer or choking-coil, applicable to the quality control of magnetic devices for the electronic industry.

A method for measuring the thermal resistance and an apparatus for measuring the thermal resistance of such components as LSI circuits are known from an American patent specification US no. 4.840.495. That known method consists in that the thermal resistance is determined based on a measurement of the temperature difference between both sides of an integrated circuit through which a known heat flux flows. The known measuring system consists of a heat source, a source of cold, the system under test, a temperature difference meter and a control system.

A cooling device for reducing the thermal resistance of transformer windings is known from a Taiwan patent specification TW000200828355A. According to that known solution, a thin insulating layer which is thermally conductive is placed between each pair of winding layers. Owing to that layer conduction to the outside of heat generated in the winding is facilitated. This ensures reduction of the transformer thermal resistance.

Another solution, known from a Chinese patent specification CN 000002269589Y, concerns an internally protected high-temperature measuring and recording device. That device is designed for use in measuring instruments operating at high temperatures from 1000°C to 2000°C. The device contains a temperature probe, optical fibers, a multi-range pyrometer and a data analyzer operating in conjunction with special software. The temperature probe, containing a metal oxide crystal, is the main component; the probe housing is protected with a special ceramic. Information about the temperature value is converted into light, which is transmitted via an optical fiber to the pyrometer.

In another solution, known from a Polish patent specification no. PL 187668, a measuring method and a system for measuring the thermal resistance of a smart unipolar power integrated circuit are presented. That known measuring method includes as a first stage calibration of the thermometric characteristics of the p-n junction contained in the structure of an output MOS transistor, at one value of the ambient temperature and a current forced by a source of the measuring current $I_M$, and determination of the slope of that characteristics. The second stage of that solution consists in applying to the integrated circuit examined a power wave and measuring the steady state voltage values at a voltage node for a high power level and low power level. The third stage of that known method consists in determining the thermal resistance value from an analytic formula.

The known measuring system contains sources of the measuring and heating currents, two switches, a measuring amplifier, converter and computer. During the measurement appropriate digital signals are applied across the control input of the integrated circuit examined, their sequence depending on that integrated circuit type.

Another Polish patent specification, no. PL 206218, describes a method and system for measuring the thermal resistance of an integrated pulse controller. A system according to that known solution contains a thermostat, digital oscilloscope, analog-to-digital converter and computer. In that system the input voltage source is connected to the input of the controller under examination through a semiconductor power switch controlled with a digital signal from the computer. A source of negative voltage is also connected, via a resistor and the analog-to-digital converter input, to the input of the controller examined. Inputs of the two-channel digital oscilloscope, a resistor and components of the application system of the controller under examination are connected to terminals of a semiconductor keying element integrated in the controller structure. The digital oscilloscope and the analog-to-digital converter are connected to the control computer. In that known method the measurement of the thermal resistance of the integrated pulse controller operating in a BOOST converter configuration is based on using as a thermally sensitive parameter a voltage on a surface mount diode polarized in the direction of current flow. The resistance measurement is accomplished here in three stages, covering determination of the thermometric characteristics slope, measurement of the voltage across the surface mount diode during calibration and in the steady state, and calculation of the thermal resistance value from an analytic formula. The method under consideration is characterized in that the controller examined operates in the second stage of measurement in its application system and generates a pulse power waveform, the value of power P used in the final formula of this method being determined by averaging a product of voltage and current waveforms measured at the terminals of the semiconductor power keying element integrated in the examined controller structure. The thermal resistance value is calculated from a known formula.

A measurement of the thermal resistance of a semiconductor device is known from another Japanese patent specification no. JP 59108968. The measurement is made using as a thermally sensitive parameter the current gain G of an amplifier containing a unipolar transistor. The transistor is fed with a high frequency signal, and the measurement of the thermal resistance is carried out in 6 stages, covering measurements of voltages at transistor terminals under different conditions of its power supply and calculation of the thermal resistance value from an analytic formula.

Still another known method of measuring the thermal resistance of a field effect transistor has been presented in a Japanese patent specification no. JP 59092364. That known method is designed for measurements of microwave unipolar transistors. In that method the threshold voltage of the transistor examined is used as a thermally sensitive parameter. The thermal resistance value is determined from the defining formula, and the transistor examined is supplied with a pulse signal having a pulse-duty factor of 0.99.

Known German patent DD 240461 refers the manner of testing primary windings of inductive voltage transformers. Particularly, it describes the manner of detecting inter turn short-circuits of the primary winding composed of many turns of thin wire. In the well-known manner the examined transformer is heated up until the admissible operating temperature of this element is achieved by stimulating the primary winding with the pulses train of current until the thermally steady state is obtained. Afterwards, the primary winding is stimulated by alternating voltage, and on the load the overvoltage is obtained by including and switching off impedance in the exciting circuit.

In the known article entitled "Temperature measurement of high-density winding coils of electromagnets" by K.T. Son and C.C. Lee published in IET Science Measurement and Technology 2012, Vol. 6, No. 1, pp. 1-5 the manner of temperature measurements of the winding of the electromagnet is proposed. In the worked out method electric conductivity of the winding as the thermally-sensitive parameter is used. However, the authors of the cited paper propose measurements of mutual thermal resistance between the winding and the case of the electromagnet, instead of thermal resistance between the winding and the surrounding.

According to the invention the method of claim 1 for measuring the own thermal resistance of a magnetic device in the form of a choking-coil and the mutual thermal resistance between the core and winding of the choking-coil consists in that the measured winding resistance, whose thermometric characteristics slope describes the temperature coefficient of copper resistivity changes $\rho_{Cu}$, is used as a thermally sensitive parameter. The measurement is carried out in three stages, including in turn measurements and calculations based on analytical formulae.

The measuring method according to the invention is characterized in that at the first stage of measurement the winding resistance $R_3$ is measured at a low value of the current $I_3$ and the core temperature $T_a$ is measured using a radiometric pyrometer. The second stage covers measurement, in a thermal steady state, of the winding resistance $R_4$ and measurement of the choking-coil core temperature $T_r$ with a radiometric pyrometer at a high value of the choking-coil current $I_4$. At the third stage the value of the winding thermal resistance $R_{thu}$ and the mutual thermal resistance between the choking-coil core and the winding, $R_{thur}$, are calculated from formulae:

$$R_{thu} = \frac{R_4 - R_3}{R_3 \cdot \rho_{Cu} \cdot I_4^2 \cdot R_4}$$

$$R_{thur} = \frac{T_r - T_a}{I_4^2 \cdot R_4}$$

where the respective symbols denote:

$R_3$ - choking-coil resistance at the first stage of measurement,
$R_4$ - choking-coil resistance at the second stage of measurement,
$I_4$ - choking-coil current at the second stage of measurement,
$T_a$ - core temperature at the first stage of measurement,
$T_r$ - core temperature at the second stage of measurement,
$R_{thu}$ - thermal resistance of the choking-coil winding,
$R_{thur}$ - mutual thermal resistance between the choking-coil winding and core.

According to the invention the method of claim 2 for measuring the own thermal resistance of a magnetic device in the form of a transformer, the own thermal resistance of the core and the mutual thermal resistance between the transformer core and winding consists in that the measured winding resistance, whose thermometric characteristics slope describes the temperature coefficient of copper resistivity changes $\rho_{Cu}$, is used as a thermally sensitive parameter. The measurement is carried out in five stages, including in turn measurements and calculations based on analytical formulae.

The method according to the invention is characterized in that at the first stage of measurement the primary winding resistance $R_1$ is measured at a low value of the current $I_1$ in that winding, the secondary winding resistance $R_2$ is measured at a low value of the current $I_2$ in that winding and the core temperature $T_a$ is measured using a radiometric pyrometer. The second stage includes a measurement, in a thermal steady state, of the transformer primary winding resistance $R_{11}$ and the transformer secondary winding resistance $R_{22}$, and a measurement of the transformer core temperature $T_r$ with a pyrometer at a high value of the current in the primary winding $I_{11}$ and a low value of the current in the secondary winding $I_2$. At the third stage the values of the primary winding thermal resistance $R_{thup}$ and the mutual thermal resistance between the transformer primary and secondary windings, $R_{thupw}$, are measured. Next, the value of the mutual thermal resistance between the primary winding and the core, $R_{thur}$, is calculated from formulae:

$$R_{thup} = \frac{R_{11} - R_1}{R_1 \cdot \rho_{Cu} \cdot I_{11}^2 \cdot R_{11}}$$

$$R_{thupw} = \frac{R_{22} - R_2}{R_2 \cdot \rho_{Cu} \cdot I_{11}^2 \cdot R_{11}}$$

$$R_{thur} = \frac{T_r - T_a}{I_{11}^2 \cdot R_{11}}$$

where the respective symbols denote:

$I_{11}$ - primary winding current at the second stage of measurement,

$R_1$ - primary winding resistance at the first stage of measurement,

$R_2$ - secondary winding resistance at the first stage of measurement,

$R_{11}$ - primary winding resistance at the second stage of measurement,

$T_a$ - core temperature at the first stage of measurement,

$T_r$ - core temperature at the second stage of measurement,

$R_{thupw}$ - thermal resistance of the primary winding,

$R_{thur}$ - mutual thermal resistance between the primary winding and core,

$\rho_{Cu}$ - temperature coefficient of copper resistivity changes.

At the fourth stage a sinusoidal signal is applied across the primary winding, its frequency and phase selected so that the transformer core operates below the saturation range, and the primary winding current waveform $i_1(t)$ and voltage waveform $u_C(t)$ at the output of an integrating circuit are recorded with an oscilloscope. The integrating circuit is supplied from the transformer secondary winding. The core temperature $T_{r1}(t)$ is recorded with a radiometric pyrometer, and at the fifth stage the value of core thermal resistance is calculated according to the formula:

$$R_{thr} = \frac{T_{r1} - T_a - R_{thur} \cdot i_{1sk}^2 \cdot R_1}{P_R}$$

where $i_{1sk}$ denotes the rms value of the $i_1(t)$ current, and $P_R$ denotes the power dissipated in the core, which is equal to the area of the hysteresis loop B(H) measured with the oscilloscope in the steady state. Values of the magnetic flux density B and magnetic force H are calculated from known formulae:

$$B = \frac{R \cdot C \cdot u_C}{z_2 \cdot S_{Fe}}$$

$$H = \frac{z_1 \cdot i_1}{l_{Fe}}$$

where R and C denote the resistance and capacitance, respectively, of a resistor and capacitor connected to the secondary winding, $z_2$ is the number of secondary winding turns, $S_{Fe}$ is the core cross section area, and $l_{Fe}$ is the length of the magnetic path in the core.

According to the invention the circuit of claim 3 for measuring own and mutual thermal resistances of a magnetic device comprises voltmeters, ammeters, an oscilloscope, DC voltage sources, double-throw switches and a radiometric pyrometer. The circuit also contains a source of sinusoidal signal, resistors and a capacitor. According to the invention the circuit is characterized in that the voltmeter is connected in parallel with the input terminals Z1 and Z2 of the magnetic device winding, while a resistor Rw, the first ammeter and a double-throw switch are connected in series with that winding of the magnetic device. The source of sinusoidal signal is connected between the first ammeter and the B terminal of the double-throw switch $S_1$, whereas the first source of DC voltage is connected between the first ammeter and the A terminal of the double-throw switch $S_1$. Z3 and Z4 terminals of the magnetic device are connected in series with the double-throw switch $S_2$, while between the D terminal of the double-throw switch $S_2$ and the ground a resistor R and capacitor C are connected in series. Between the C terminal of the switch $S_2$ and the ground a second voltmeter is connected, and a second ammeter in a series connection with a second DC voltage source are connected in parallel with that second voltmeter. The input of the oscilloscope X channel is connected to the common point of the sinusoidal signal source, first source of DC voltage and first ammeter, whereas the input of the oscilloscope Y channel is connected to the common point of the capacitor and resistor. The magnetic device is provided with Kelvin contacts, whereas the radiometric pyrometer input is located opposite to the magnetic device core.

A choking-coil whose winding is connected between Z1 and Z2 terminals has been foreseen as the magnetic device in the circuit according to the invention.

According to the invention a transformer may be the magnetic device under consideration, its primary winding having been connected between Z1 and Z2 terminals, while the secondary winding may be connected between Z3 and Z4 terminals.

The possibility of determining the own thermal resistance of the magnetic device is a favorable result of adopting the method according to the invention. For a magnetic device in the form of a transformer the primary winding thermal resistance, own thermal resistance of the core, mutual thermal resistances between the primary and secondary windings and mutual thermal resistances between the primary winding and the core are concerned. The method according to the invention is easily implemented using uncomplicated procedures and measuring instruments. The results of measurements make it possible to determine the maximum value of the winding current and frequency of the signal processed, for which the permissible value of the transformer windings and core temperature is not exceeded.

The possibility of measuring the own thermal resistance of a magnetic device, including the thermal resistances of the transformer primary and secondary windings and core, the mutual thermal resistances between the primary and secondary windings, and the primary windings and transformer core, which determine the permissible values of the winding current and frequency during the transformer operation is a favorable effect brought about by use of the circuit according to the invention.

The object of the invention is presented below in embodiments showing examples of implementation of the method for measuring own and mutual thermal resistances of a magnetic device and a circuit for measuring own and mutual thermal resistances of a magnetic device.

Example I.

In this embodiment the method for measuring the thermal resistance of the winding and the mutual thermal resistance between the core and the winding of a magnetic device in the form of a choking-coil is presented. The measurement is carried out in three stages. During the measurement the switch $S_1$ 14 is at the A position. The resistance $R_1$ of the choking-coil winding corresponding to the ambient temperature and the core temperature are measured at the first stage. During the first stage of measurements the output of the DC source 1 is set so that a low value current flows in the circuit. That value is selected so that no winding temperature rise be caused, and simultaneously the current be much higher than that drawn by the first voltmeter 5. The recommended value of this current is 10 mA. The ammeter 3 measures the choking-coil current, and the voltmeter 5 - the voltage across its winding. The value of the resistance $R_1$ is calculated as a quotient of the values measured by voltmeter 5 and ammeter 3. The core temperature $T_a$ is measured with the radiometric pyrometer 12. In order to eliminate the influence of leads on the measurement results Kelvin contacts are used for connection to the choking-coil examined, voltage terminals being connected to the voltmeter 5 and current terminals being connected to the ammeter 3 and the ground.

At the second stage of measurement the DC voltage source 1 forces a flow of the heating current $I_2$ in the choking-coil winding, the current intensity being sufficient to increase the winding temperature by at least 20°C. The current value is measured with the ammeter 3 and the voltage across the choking-coil is measured with the voltmeter 5. The quotient of the voltmeter 5 and ammeter 3 readings is equal to the winding resistance. This resistance increases with time until a steady state is reached. The steady state is achieved when the instantaneous value of the winding resistance does not change in 1 minute by more than 1%. The steady state value of this resistance is the winding resistance $R_2$ at the second stage of measurement. Also the core tem-

perature $T_r$ is measured in the steady state, the radiometric pyrometer 12 being used for that purpose.

The third stage of measurement involves calculation of the winding thermal resistance $R_{thu}$ and the mutual thermal resistance between the core and the winding $R_{thur}$ using the formulae

$$R_{thu} = \frac{R_2 - R_1}{R_1 \cdot \rho_{Cu} \cdot I_2^2 \cdot R_2}$$

$$R_{thur} = \frac{T_r - T_a}{I_2^2 \cdot R_2}$$

where $\rho_{Cu}$ denotes the temperature coefficient of copper resistivity changes.

Example II.

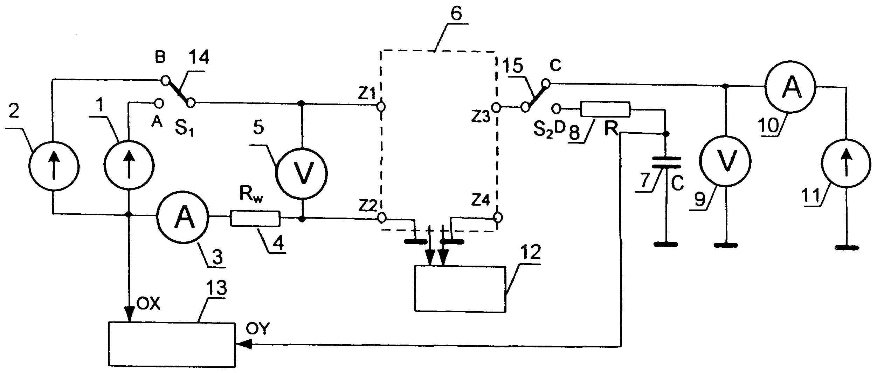

Example I was concerned with the method for measuring own and mutual thermal resistances of a choking-coil in three stages. The present example deals with the method for measuring own and mutual thermal resistances of the primary and secondary windings and the core of a magnetic device in the form of a transformer. In this example the measurement in a circuit as shown in the drawing enclosed is accomplished in five stages, including in turn measurements and calculations from analytic formulae.

At the first stage of measurement the primary winding resistance $R_1$ is measured at a low value of the current $I_1$ in that winding, the secondary winding resistance $R_2$ is measured at a low value of the current $I_2$ in that winding and the core temperature $T_a$ is measured using radiometric pyrometer. During the first stage of measurement the switches $S_1$ 14 and $S_2$ 15 are switched to the position 1. Outputs of the first DC voltage source 1 and the second DC voltage source 11 are set to a low current value, selected so that no winding temperature rise is caused, while at the same time the current is much higher than that drawn by the voltmeter. The recommended value of this current is 10 mA. The first ammeter 3 measures the current in the primary winding and the first voltmeter 5 measures the voltage across that winding. The second voltmeter 9 measures the voltage across the secondary winding, whereas the second ammeter 10 measures the current in that winding. The value of the resistance $R_1$ is calculated as a quotient of the voltage measured with the first voltmeter 5 divided by the current measured with the first ammeter 3, while the value of the resistance $R_2$ is calculated as a quotient of the voltage measured with the second voltmeter 9 divided by the current measured with the second ammeter 10. The core temperature $T_a$ is measured with a radiometric pyrometer 12. In order to eliminate the influence of leads on the measurement results Kelvin contacts are used for connection to the transformer examined, voltage terminals being connected to the voltmeters and current terminals being connected to the ammeters and the ground.

At the second stage of measurement the first switch 14 is at the A position, and the second switch 15 is at the C position. The DC voltage source 1 forces a flow of the heating current in the transformer primary winding, the current intensity being sufficient to increase the winding temperature by at least 20°C. The value of that current $I_{11}$ is measured with the first ammeter 3 and the voltage across the primary winding is measured with the voltmeter 5. The quotient of the voltmeter 5 and ammeter 3 readings is equal to the primary winding resistance. At the same time the second DC voltage source 11 is used to force a low value DC current in the secondary winding of the transformer 6. The value of that current $I_2$ is measured with the second ammeter 10 and the voltage across the secondary winding is measured with the second voltmeter 9. The quotient of the second voltmeter 9 and the second ammeter 10 readings is equal to the secondary winding resistance. These resistances increase with time until a steady state is reached. The steady state is achieved when the instantaneous value of the winding resistance does not change by more than 1% in 1 minute. The steady state value of the primary winding resistance is the resistance $R_{11}$ of that winding at the second stage of measurement, and the steady state value of the secondary winding resistance is the resistance $R_{22}$ of that winding at the second stage of measurement. Also the core temperature $T_r$ is measured in the steady state, the radiometric pyrometer 12 being used for that purpose.

At the third stage of measurement the primary winding thermal resistance value is calculated from the following analytic relation

$$R_{thup} = \frac{R_{11} - R_1}{R_1 \cdot \rho_{Cu} \cdot I_{11}^2 \cdot R_{11}}$$

where $\rho_{Cu}$ denotes the temperature coefficient of copper resistivity changes. The value of the mutual thermal resistance between the primary and secondary windings of the transformer is calculated from the formula

$$R_{thupw} = \frac{R_{22} - R_2}{R_2 \cdot \rho_{Cu} \cdot I_{11}^2 \cdot R_{11}}$$

The value of the mutual thermal resistance between the primary winding and the core is calculated from the formula

$$R_{thur} = \frac{T_r - T_a}{I_{11}^2 \cdot R_{11}}$$

At the fourth stage the first switch $S_1$ 14 is positioned at B and the second switch $S_2$ is positioned at

D. Then across the primary winding a signal is applied from the sinusoidal signal source 2, its frequency and phase selected so that the transformer core does not operate in the saturation range, while at the same time the power dissipated in the core causes a substantial rise of the core temperature. An integrating circuit consisting of a resistor 8 and capacitor 7 is connected to the secondary winding. With such excitation the primary winding current waveform $i_1(t)$ and voltage waveform $u_C(t)$ at the output of the integrating circuit are recorded with the oscilloscope 13. Also the core temperature $T_{r1}(t)$ is recorded using a radiometric pyrometer. When the steady state is achieved, that is when the temperature indicated by the pyrometer does not change by more than 0,5°C within one minute, waveforms $i_1(t)$ and $u_C(t)$ corresponding to one period of the exciting signal from the sinusoidal signal source 2, and the core temperature $T_{r1}$ measured in the steady state are saved in the oscilloscope memory.

At the fifth stage of measurement values of the core thermal resistance are calculated from the analytic formula shown below, based on the results of measurements in the steady state obtained at the fourth stage

$$R_{thr} = \frac{T_{r1} - T_a - R_{thur} \cdot i_{1sk}^2 \cdot R_1}{P_R}$$

wher $i_{1sk}$ denotes the rms value of the current $i_1(t)$, and $P_R$ denotes the power dissipated in the core. The value of $P_R$ is equal to the area of the hysteresis loop B(H) measured with the oscilloscope in the steady state. Values of the magnetic flux density B and magnetic force H are calculated from known formulae:

$$B = \frac{R \cdot C \cdot u_C}{z_2 \cdot S_{Fe}}$$

$$H = \frac{z_1 \cdot i_1}{l_{Fe}}$$

where R and C denote the resistance and capacitance, respectively, of the resistor 8 and capacitor 7, $z_2$ is the number of secondary winding turns, $S_{Fe}$ is the core cross section area, and $l_{Fe}$ is the length of the magnetic path in the core.

Example III.

The drawing enclosed shows a block diagram of a circuit for measuring the thermal resistance of a magnetic device, taking as an example a choking-coil and a transformer. The thermal resistance of windings and core of the transformer and the mutual thermal resistance between the windings as well as the mutual thermal resistance between the primary winding and the transformer core are subject to the measurements.

The circuit according to that embodiment contains terminals for connecting the magnetic device under test 6, such as a choking-coil or transformer or another magnetic device, two voltmeters 5,9, two ammeters 3,10, a radiometric pyrometer 12, two DC voltage sources 1,11, a sinusoidal voltage source 2, two double-throw switches 14,15, an oscilloscope 13, two resistors 4,8 and a capacitor 7. The voltmeter 5 is connected in parallel with the winding of the magnetic device 6, while the resistor $R_W$ 4, the first ammeter 3 and the double-throw switch 14 are connected in series with this winding. The source of sinusoidal signal 2 is connected between the first ammeter 3 and the B terminal of the double-throw switch $S_1$ 14, whereas the first DC voltage source 1 is connected between the first ammeter 3 and the A terminal of that double-throw switch $S_1$ 14. In the case of measurements for a magnetic device in the form of a transformer the secondary winding of the transformer is connected in series with the double-throw switch $S_2$ 15. The resistor R 8 and the capacitor C 7 are connected in series between the D terminal of that switch and the ground. Between the C terminal of the switch $S_2$ 15 and the circuit common the second voltmeter 9 is connected, while the second ammeter 10 and the second DC voltage source 11 in a series connection are connected in parallel with that voltmeter. The X channel of the oscilloscope 13 is connected to the connection point of the sinusoidal signal source 2, DC voltage source and first ammeter 3. The Y channel of the oscilloscope 13 is connected with the connection point of the capacitor 7 and the resistor 8. The magnetic device 6 in the form of a transformer is provided with Kelvin contacts, and the infrared radiation emitted by the transformer core is detected by the radiometric pyrometer 12.

When the circuit according to the invention is used for measurements of the thermal resistance of a magnetic device 6 in the form of a choking-coil, the choking-coil windings is connected between the Z1 and Z2 terminals of the circuit as shown in the enclosed drawing.

**List of denotations in the drawing.**

| 1 | - first DC voltage source |
|---|---|
| 2 | - sinusoidal voltage source |
| 3 | - first ammeter |
| 4 | - resistor $R_w$ |
| 5 | - first voltmeter |
| 6 | - magnetic device under examination |
| 7 | - capacitor C |
| 8 | - resistor R |
| 9 | - second voltmeter |
| 10 | - second ammeter |
| 11 | - second DC voltage source |
| 12 | - radiometric pyrometer |
| 13 | - digital oscilloscope |
| 14 | - double-throw switch $S_1$ |
| 15 | - double-throw switch $S_2$ |
| $I_1$ | - primary winding current at the first stage of measurement |
| $I_2$ | - secondary winding current at the first and second stages of the measurement |
| $I_{11}$ | - primary winding current at the second stage of measurement |
| $R_1$ | - primary winding resistance at the first stage of measurement |
| $R_2$ | - secondary winding resistance at the first stage of measurement |
| $R_{11}$ | - primary winding resistance at the second stage of measurement |
| $R_3$ | - choking-coil resistance at the first stage of measurement |
| $R_4$ | - choking-coil resistance at the second stage of measurement |
| $T_a$ | - core temperature at the first stage of measurement |
| $T_r$ | - core temperature at the second stage of measurement |
| $T_{r1}$ | - core temperature at the fourth stage of measurement |
| $R_{thup}$ | - thermal resistance of the primary winding |
| $R_{thuw}$ | - thermal resistance of the secondary winding |
| $R_{thr}$ | - thermal resistance of the core |
| $R_{thur}$ | - mutual thermal resistance between the primary winding and the core |

$R_{thu}$    - thermal resistance of the choking-coil winding

$R_{thur}$    - mutual thermal resistance between the choking-coil winding and core

$\rho_{Cu}$    - temperature coefficient of copper resistivity changes

$S_1$    - first switch

B    - position of $S_1$ switch at the fourth stage of measurement

A    - position of $S_1$ switch at the first and second stages of measurement

Ox    - input of oscilloscope X channel

Oy    - input of oscilloscope Y channel

$S_2$    - second switch

C    - position of $S_2$ switch at the first and second stages of measurement

D    - position of $S_2$ switch at the fourth stage of measurement

Z1    - first terminal of the magnetic device primary winding

Z2    - second terminal of the magnetic device primary winding

Z3    - first terminal of the magnetic device secondary winding

Z4    - second terminal of the magnetic device secondary winding

## Claims

1. A method for measuring the own thermal resistance of a magnetic device in the form of a choking-coil and the mutual thermal resistance between the core and winding of the choking-coil, where the winding resistance, whose thermometric characteristics slope describes the temperature coefficient of copper resistivity changes $\rho_{Cu}$, is measured as a thermally sensitive parameter, the measurement being carried out in three stages, including in turn measurements and calculations based on analytical formulae, **characterized in that** at the first stage of measurement the winding resistance $R_3$ is measured at a low value of the current $I_3$ and the core temperature $T_a$ is measured using a radiometric pyrometer, at the second stage measurements are made, in a thermal steady state, of the winding resistance $R_4$ and, with a radiometric pyrometer, the choking-coil core temperature $T_r$ at a high value of the choking-coil current $I_4$, and at the third stage the value of the winding thermal resistance $R_{thu}$ and the mutual thermal resistance between the choking-coil core and the winding, $R_{thur}$, are calculated from formulae:

$$R_{thu} = \frac{R_4 - R_3}{R_3 \cdot \rho_{Cu} \cdot I_4^2 \cdot R_4}$$

$$R_{thur} = \frac{T_r - T_a}{I_4^2 \cdot R_4}$$

where the respective symbols denote:

$R_3$ - choking-coil resistance at the first stage of measurement,
$R_4$ - choking-coil resistance at the second stage of measurement,
$I_4$ - choking-coil current at the second stage of measurement,
$T_a$ - core temperature at the first stage of measurement,
$T_r$ - core temperature at the second stage of measurement,
$R_{thu}$ - thermal resistance of the choking-coil winding,
$R_{thur}$ - mutual thermal resistance between the choking-coil winding and core.

2. A method for measuring the own thermal resistance of a magnetic device in the form of a transformer, the own thermal resistance of the core and the mutual thermal resistance between the transformer core and winding, where the winding resistance, whose thermometric characteristics slope describes the temperature coefficient of copper resistivity changes $\rho_{Cu}$, is measured as a thermally sensitive parameter, the measurement being carried out in five stages, including in turn measurements and calculations based on analytical formulae, **characterized in that** at the first stage of measurement the primary winding resistance $R_1$ is measured at a low value of the current $I_1$ **in that** winding, the secondary winding resistance $R_2$ is measured at a low value of the current $I_2$ **in that** winding and the core temperature $T_a$ is measured using a radiometric pyrometer, at the second stage measurements are made, in a thermal steady state, of the transformer primary winding resistance $R_{11}$, the transformer secondary winding resistance $R_{22}$, and, with a pyrometer, the transformer core temperature $T_r$ at a high value of current in the primary winding $I_{11}$ and a low value of current in the secondary winding $I_2$, at the third stage the values of the primary winding thermal resistance $R_{thup}$ and the mutual thermal resistance between the transformer primary and secondary windings, $R_{thupw}$, are measured and next the value the mutual thermal resistance between the primary winding and the core, $R_{thur}$, is calculated from formulae:

$$R_{thup} = \frac{R_{11} - R_1}{R_1 \cdot \rho_{Cu} \cdot I_{11}^2 \cdot R_{11}}$$

$$R_{thupw} = \frac{R_{22} - R_2}{R_2 \cdot \rho_{Cu} \cdot I_{11}^2 \cdot R_{11}}$$

$$R_{thur} = \frac{T_r - T_a}{I_{11}^2 \cdot R_{11}}$$

where the respective symbols denote:

$I_{11}$ - primary winding current at the second stage of measurement,
$R_1$ - primary winding resistance at the first stage of measurement,
$R_2$ - secondary winding resistance at the first stage of measurement,
$R_{11}$ - primary winding resistance at the second stage of measurement,
$T_a$ - core temperature at the first stage of measurement,
$T_r$ - core temperature at the second stage of measurement,
$R_{thupw}$ - thermal resistance of the primary winding,
$R_{thur}$ - mutual thermal resistance between the primary winding and core,
$\rho_{Cu}$ - temperature coefficient of copper resistivity changes,

whereas at the fourth stage a sinusoidal signal is applied across the primary winding, its frequency and phase selected so that the transformer core operates below the saturation range, and the primary winding current waveform $i_1(t)$ and voltage waveform $u_C(t)$ at the output of an integrating circuit are recorded, the integrating circuit being supplied from the transformer secondary winding through an oscilloscope, and the core temperature $T_{r1}(t)$ being recorded with a radiometric pyrometer, while at the fifth stage the value of the core thermal resistance is calculated from the formula:

$$R_{thr} = \frac{T_{r1} - T_a - R_{thur} \cdot i_{1sk}^2 \cdot R_1}{P_R}$$

where $i_{1sk}$ denotes the rms value of the $i_1(t)$ current, $P_R$ denotes the power dissipated in the core, which is equal to the area of the hysteresis loop B(H) measured with the oscilloscope in the steady state, and values of the magnetic flux density B and magnetic force H are calculated from known formulae.

3. A circuit for measuring own and mutual thermal resistances of a magnetic device, comprising voltmeters, ammeters, an oscilloscope, DC voltage sources, double-throw switches, a radiometric pyrometer, a source of sinusoidal signal, resistors and a capacitor, **characterized in that** the voltmeter (5) is connected in parallel with the input terminals Z1 and Z2 of the magnetic device (6) winding, while the resistor Rw (4), the first ammeter (3) and the double-throw switch (14) are connected in series with that winding of the magnetic device (6), the sinusoidal signal source (2) being connected between the first ammeter (3) and the B terminal of the double-throw switch $S_1$ (14), whereas the first source of DC voltage (1) is connected between the first ammeter (3) and the A terminal of the double-throw switch $S_1$ (14), the Z3 and Z4 terminals being connected in series with the double-throw switch $S_2$ (15), while between the D terminal of the double-throw switch $S_2$ (15) and the circuit common the resistor R (8) and capacitor C (7) are connected in series, between the C terminal of the switch $S_2$ (15) and the circuit common a second voltmeter (9) being connected, while a second ammeter (10) in a series connection with a second DC voltage source (11) are connected in parallel with the second voltmeter (9), the input of the oscilloscope (13) X channel is connected to the common point of the sinusoidal signal source (2), first source of DC voltage (1) and first ammeter (3), whereas the input of the oscilloscope (13) Y channel is connected to the common point of the capacitor (7) and resistor (8), the magnetic device (6) being provided with Kelvin contacts, while the input of the radiometric pyrometer (12) is located opposite to the core of the magnetic device (6).

4. A circuit according to claim 3, **characterized in that** the magnetic device (6) is a choking-coil whose winding is connected between the Z1 and Z2 terminals.

5. A circuit according to claim 3, **characterized in that** the magnetic device (6) is a transformer whose primary winding is connected between the Z1 and Z2 terminals, while the secondary winding is connected between the Z3 and Z4 windings.

**Patentansprüche**

1. Das Verfahren zur Messung eigener thermischer Widerstände in Form einer Drossel und gemeinsamer thermischer Widerstände zwischen dem Drosselkern und der Drosselwicklung, wobei Wicklungswiderstand als wärmeempfindlicher Parameter gemessen wird und dessen Neigung der thermometrischen Kennlinie durch den Temperaturkoeffizienten der Widerstandsänderung von Kupfer pcu beschrieben wird, wobei die Messung in drei Stufen erfolgt, in den Messungen und die durch die Formel festgelegten Berechnungen durchgeführt werden, **dadurch gekennzeichnet, dass** in der ersten Stufe der Messung der Wicklungswiderstand $R_3$ bei niedrigem Strom der Drossel $I_3$ und die Temperatur $T_a$ des Drosselkerns mithilfe eines radiometrischen Pyrometers gemessen wird, in der zweiten Stufe der Wicklungswiderstand $R_4$ der Wicklung und die Temperatur $T_r$ des Drosselkerns im thermisch stationären Zustand mithilfe eines radiometrischen Pyrometers bei hohem Strom der Drossel $I_4$ gemessen wird und in der dritten Stufe der Wert des thermischen Widerstands der $R_{thu}$-Wicklung und des gemeinsamen thermischen Widerstands zwischen dem Kern und der $R_{thu}$-Wicklung aus der folgenden Formel berechnet wird:

$$R_{thu} = \frac{R_4 - R_3}{R_3 \cdot \rho_{Cu} \cdot I_4^2 \cdot R_4}$$

$$R_{thur} = \frac{T_r - T_a}{I_4^2 \cdot R_4}$$

Zeichenerklärung:

$R_3$ - Widerstand der Drossel in der ersten Stufe der Messung

$R_4$ - Widerstand der Drossel in der zweiten Stufe der Messung

$I_4$ - Strom der Drossel in der zweiten Stufe der Messung

$T_a$ - Kerntemperatur in der ersten Stufe der Messung

$T_r$ - Kerntemperatur in der zweiten Stufe der Messung

$R_{thu}$ - thermischer Widerstand der Drosselwicklung

$R_{thur}$ - gemeinsamer thermischer Widerstand zwischen der Drosselwicklung und dem Drosselkern

2. Das Verfahren zur Messung eigener thermischer Widerstände in Form eines Transformators, eigener thermischer Widerstände des Kerns und gemeinsamer thermischer Widerstände zwischen dem Transformatorkern und der Transformatorwicklung, wobei Wicklungswiderstand als wärmeempfindlicher Parameter gemessen wird und dessen Neigung der thermometrischen Kennlinie durch den Temperaturkoeffizienten der Widerstandsänderung von Kupfer pcu beschrieben wird, wobei die Messung in fünf Stufen erfolgt, in den Messungen und die durch die Formel festgelegten Berechnungen durchgeführt werden, **dadurch gekennzeichnet, dass** in der ersten Stufe der Messung der Primärwicklungswiderstand des Transformators $R_1$ bei niedrigem Wicklungsstrom $I_1$, der Sekundärwicklungswiderstand $R_2$ bei niedrigem Wicklungsstrom $I_2$ sowie die Temperatur $T_a$ des Transformatorkerns mithilfe eines radiometrischen Pyrometers gemessen wird, in der zweiten Stufe der Messung der Primärwicklungswiderstand $R_{11}$, der Sekundärwicklungswiderstand $R_{22}$ und die Temperatur $T_r$ des Transformatorkerns im thermisch stationären Zustand mithilfe eines radiometrischen Pyrometers bei hohem Strom der Primärwicklung $I_{11}$ und bei niedrigem Strom der Sekundärwicklung $I_2$ gemessen wird und in der dritten Stufe der Wert des thermischen Widerstands der Primärwicklung $R_{thup}$ und des gemeinsamen thermischen Widerstands zwischen der Primärwicklung und der Sekundärwicklung $R_{thupw}$ und schließlich der Wert des gemeinsamen thermischen Widerstands zwischen der Primärwicklung und dem Kern $R_{thur}$ aus den folgenden Formeln berechnet wird:

$$R_{thup} = \frac{R_{11} - R_1}{R_1 \cdot \rho_{Cu} \cdot I_{11}^2 \cdot R_{11}}$$

$$R_{thupw} = \frac{R_{22} - R_2}{R_2 \cdot \rho_{Cu} \cdot I_{11}^2 \cdot R_{11}}$$

$$R_{thur} = \frac{T_r - T_a}{I_{11}^2 \cdot R_{11}}$$

Zeichenerklärung:

$I_{11}$ - Primärwicklungsstrom in der zweiten Stufe der Messung,

$R_1$ - Primärwicklungswiderstand in der ersten Stufe der Messung,

$R_2$ - Sekundärwicklungswiderstand in der ersten Stufe der Messung,

$R_{11}$ - Primärwicklungswiderstand in der zweiten Stufe der Messung,

$T_a$ - Kerntemperatur in der ersten Stufe der Messung,

$T_r$ - Kerntemperatur in der zweiten Stufe der Messung,

$R_{thupw}$ - thermischer Primärwicklungswiderstand,

$R_{thur}$ - gemeinsamer thermischer Widerstand zwischen der Primärwicklung und dem Kern,

$\rho_{Cu}$ - Temperaturkoeffizient der Widerstandsänderung von Kupfer,

in der vierten Stufe die Primärwicklung mit einem kleinen sinusförmigen Signal angeregt wird, wobei die Frequenz und Amplitude so eingestellt werden, dass der Transformatorkern unter dem Sättigungsbereich funktioniert und der zeitliche Verlauf der Primärwicklungsstroms $i_1(t)$ und der Spannungsverlauf uc(t) am Ausgang des Integrators aufgezeichnet werden, der mittels eines Oszilloskops von der Sekundärwicklung des Transformators gespeist wird, während die Kerntemperatur $T_{r1}(t)$ mithilfe eines radiometrischen Pyrometers aufgezeichnet wird und in der fünften Stufe der Wert des thermischen Kernwiderstands aus der folgenden Formel berechnet wird:

$$R_{thr} = \frac{T_{r1} - T_a - R_{thur} \cdot i_{1sk}^2 \cdot R_1}{P_R}$$

wobei $i_{1sk}$ der Effektivwert des Stroms $i_1(t)$ ist, $P_R$ die Kernverlustleistung bezeichnet, die der mit dem stationären Oszilloskop gemessenen Fläche der Hystereseschleife B(H) gleich ist und wobei der Induktionswert B und die Stärke des Magnetfeldes H aus bekannten Formeln berechnet werden.

3. Schaltung zur Messung eigener und gemeinsamer thermischer Widerstände einer magnetischen Vorrichtung einschließlich Spannungsmesser, Amperemeter, Oszilloskop, Gleichstromquellen, Zweipositionsschalter, radiometrisches Pyrometer, Sinussignalquelle, Widerstände und Kondensator, **dadurch gekennzeichnet, dass** der Spannungsmesser (5) parallel zu den Eingangsklemmen Z1 und Z2 der magnetischen Vorrichtung (6) geschaltet, während der Widerstand RW (4) und das erste Amperemeter (3) und der Zweipositionsschalter (14) in Reihe mit dieser magnetischen Vorrichtung (6) geschaltet sind, wobei die Sinussignalquelle (2) zwischen dem ersten Amperemeter (3) und dem Anschluss (B) des Zweipositionsschalters $S_1$ (14) geschaltet ist, während die erste Gleichspannungsquelle (1) zwischen dem ersten Amperemeter (3) und dem Anschluss (A) des Zweipositionsschalters $S_1$ (14) geschaltet ist, und die Anschlüsse (Z3) und (Z4) in Reihe mit dem Zweipositionsschalter $S_2$ (15) geschaltet sind, wobei zwischen dem Anschluss (D) des Zweipositionsschalters $S_2$ (15) und der Masse der Widerstand R (8) und der Kondensator C (7) in Reihe geschaltet sind, wobei der zweite Spannungsmesser (9) zwischen der Leitung (C) des Schalters $S_2$ (15) und der Masse geschaltet ist, wobei das zweite Amperemeter (10) und die zweite Gleichspannungsquelle (11) in Reihe mit dem zweiten Spannungsmeter (9) geschaltet ist, während der Eingang des Kanals (X) des Oszilloskops (13) mit dem Verbindungspunkt der sinusförmigen Signalquelle (2), der ersten Gleichspannungsquelle (1) und des ersten Amperemeter (3) verbunden ist, wobei der Eingang des Kanals (Y) des Oszilloskops (13) mit dem gemeinsamen Punkt des Kondensators (7) und des Widerstands (8) verbunden ist, während die magnetische Vorrichtung (6) Kelvinkontakte hat und der Eingang des radiometrischen Pyrometers (12) dem Kern der magnetischen Vorrichtung (6) gegenüberliegt.

4. Schaltung nach Anspruch 3, **dadurch gekennzeichnet, dass** die magnetische Vorrichtung (6) eine Drossel ist, deren Wicklung zwischen den Anschlüssen (Z1) und (Z2) geschaltet ist.

5. Schaltung nach Anspruch 3, **dadurch gekennzeichnet, dass** die magnetische Vorrichtung (6) ein Transformator ist, dessen Primärwicklung zwischen den Anschlüssen (Z1) und (Z2) und die Sekundärwicklung zwischen den Anschlüssen (Z3) und (Z4) geschaltet sind.

**Revendications**

1. Procédé pour mesurer la résistance thermique individuelle d'un dispositif magnétique sous la forme de bobine d'arrêt et la résistance thermique mutuelle parmi le noyau et l'enroulement de la bobine d'arrêt où, en tant que paramètre thermosensible, la résistance de l'enroulement est mesurée dont la pente des caractéristiques thermométriques décrit le coefficient de variation de température de la résistivité du cuivre $\rho_{Cu}$, et la mesure est effectuée en trois étapes, incluant les mesurages et les calculations basées sur les formules analytiques **caractérisé en ce que** dans la première étape est mesurée la résistance d'enroulement $R_3$ à faible courant de la bobine d'arrêt $I_3$ et la température $T_a$ du noyau est mesurée en utilisant un pyromètre radiométrique, dans la deuxième étape est mesurée, en état thermique stable, la résistance $R_4$ de l'enroulement et la température $T_r$ du noyau de la bobine d'arrêt en utilisant un pyromètre radiométrique à courant élevé de la bobine d'arrêt $I_4$, et dans la troisième étape est mesurée la valeur de la résistance thermique de l'enroulement $R_{thu}$ et de la résistance thermique mutuelle parmi le noyau et l'enroulement $R_{thur}$ à partir des formules:

$$R_{thu} = \frac{R_4 - R_3}{R_3 \cdot \rho_{Cu} \cdot I_4^2 \cdot R_4}$$

$$R_{thur} = \frac{T_r - T_a}{I_4^2 \cdot R_4}$$

où les symboles individuels signifient:

R$_3$ - résistance de la bobine d'arrêt dans la première étape de la mesure

R$_4$ - résistance de la bobine d'arrêt dans la deuxième étape de la mesure

I$_4$ - courant de la bobine d'arrêt dans la deuxième étape de la mesure

T$_a$ - température du noyau dans la première étape de la mesure

T$_r$ - température du noyau dans la deuxième étape de la mesure

R$_{thu}$ - résistance thermique de l'enroulement de la bobine d'arrêt

R$_{thur}$ - résistance thermique mutuelle parmi l'enroulement et le noyau de la bobine d'arrêt

2. Procédé pour mesurer la résistance thermique individuelle d'un dispositif magnétique sous la forme de transformateur, la résistance thermique individuelle du noyau et la résistance thermique mutuelle parmi le noyau et l'enroulement du transfomateur où, en tant que paramètre thermosensible, la résistance de l'enroulement est mesurée dont la pente des caractéristiques thermométriques décrit le coefficient de variation de température de la résistivité du cuivre $\rho_{Cu}$, et la mesure est effectuée en cinq étapes, incluant les mesurages et les calculations basées sur les formules analytiques **caractérisé en ce que** dans la première étape est mesurée la résistance R$_1$ d'enroulement primaire du transformateur à faible courant de cet enroulement I$_1$, la résistance d'enroulement secondaire R$_2$ à faible courant de cet enroulement I$_2$ et la température du noyau T$_a$ est mesurée en utilisant un pyromètre radiométrique, dans la deuxième étape est mesurée, en état thermique stable, la résistance R$_{11}$ de l'enroulement primaire du transformateur, la résistance R$_{22}$ de l'enroulement secondaire du transformateur et la température T$_r$ du noyau du transformateur en utilisant un pyromètre radiométrique à courant élevé de l'enrolement primaire I$_{11}$ et à faible courant de l'enroulement secondaire I$_2$, dans la troisième étape est mesurée la valeur de la résistance thermique de l'enroulement primaire R$_{thup}$, la valeur de la résistance thermique mutuelle parmi l'enroulement primaire et l'enroulement secondaire du transformateur R$_{thupw}$, et ensuite la valeur de la résistance thermique mutuelle parmi l'enroulement primaire et le noyau R$_{thur}$ est calculée à partir des formules:

$$R_{thup} = \frac{R_{11} - R_1}{R_1 \cdot \rho_{Cu} \cdot I_{11}^2 \cdot R_{11}}$$

$$R_{thupw} = \frac{R_{22} - R_2}{R_2 \cdot \rho_{Cu} \cdot I_{11}^2 \cdot R_{11}}$$

$$R_{thur} = \frac{T_r - T_a}{I_{11}^2 \cdot R_{11}}$$

où les symboles individuels signifient:

I$_{11}$ - courant de l'enroulement primaire dans la deuxième étape de la mesure,

R$_1$ - résistance de l'enroulement primaire dans la première étape de la mesure,

R$_2$ - résistance de l'enroulement secondaire dans la première étape de la mesure,

R$_{11}$ - résistance de l'enroulement primaire dans la deuxième étape de la mesure,

T$_a$ - température du noyau dans la première étape de la mesure,

T$_r$ - température du noyau dans la deuxième étape de la mesure,

R$_{thupw}$ - résistance thermique de l'enroulement primaire,

R$_{thur}$ - résistance thermique mutuelle parmi l'enroulement primaire et le nayau,

$\rho_{Cu}$ - coefficient de variation de température de la résistivité du cuivre,

et dans la quatrième étape un signal sinusoïdal est appliqué à travers l'enroulement primaire, sa fréquence et son amplitude sont sélectionnées de sorte que le noyau du transformateur fonctionne au-dessous de la plage de saturation et le courant de la forme d'onde de l'enroulement primaire i$_1$(t) et de la forme d'onde de voltage (t) à la sortie du circuit intégrateur sont enregistrés, le circuit intégrateur étant alimenté de l'enroulement secondaire du transformateur à l'aide de l'oscilloscope et la température du noyau T$_{r1}$(t) est enregistrée par un pyromètre radiométrique tandis que dans la cinquième étape la valeur de la résistance thermique du noyau est calculée à partir de la formule:

$$R_{thr} = \frac{T_{r1} - T_a - R_{thur} \cdot i_{1sk}^2 \cdot R_1}{P_R}$$

où i$_{1sk}$ signifie la valeur efficace du courant i$_1$(t), P$_R$ signifie la puissance perdue dans le noyau qui est égale à la surface de la boucle d'hystérésis B(H) mesurée avec un oscilloscope dans l'état stable et les valeurs de la densité de flux magnétique B et la force magnétique H sont calculées à partir de formules connues.

3. Circuit pour mesurer des résistances thermiques individuelles et mutuelles d'un dispositif mangétique, comprenant voltmètres, ampèremètres, oscilloscope, sources de tension continue, commutateurs à deux positions, pyromètre radiométrique, source de signal sinusoïdal, résistances et condensateur **caractérisé en ce que** le voltmètre (5), est connecté en parallèle aux bornes d'entrée Z1 et Z2 de l'enroulement du dispositif magnétique (6), la résistance Rw (4) et le premier ampèremètre (3) et le commutateurs à deux positions (14) sont connectés en série avec l'enroulement du dispositif magnétique (6), et la source de signal sinusoïdal (2) est connectée parmi le premier ampèremètre (3) et la borne (B) du commutateur à deux positions $S_1$ (14), par contre la première source de tension continue (1) est connectée parmi le premier ampèremètre (3), et la borne (A) du commutateur à deux positions $S_1$ (14), et les bornes (Z3) et (Z4) sont connectés en série avec le commutateur à deux positions $S_2$ (15), tandis que parmi la borne (D) du commutateur à deux positions $S_2$ (15) et le circuit commun sont connectés en série la résistance R (8) et le condensateur C (7), tandis que parmi le terminal (C) du commutateur $S_2$ (15) et le circuit commun est connecté le deuxième voltmètre (9), où en parallèle avec le deuxième voltmètre (9) sont connectés en série le deuxième ampèremètre (10) et la deuxième source de tension continue (11), par contre l'entrée du canal (X) de l'oscilloscope (13) est connectée au point commun de la source de signal sinusoïdal (2) de la première source de tension continue (1) et du premier ampèremètre (3), par contre l'entrée du canal (Y) de l'oscilloscope (13) est connectée au point commun du condensateur (7) et de la résistance (8) et le dispositif magnétique (6) a les contacts Kelvin tandis qu'en face du noyau du dispositif magnétique (6) il y a l'entrée du pyromètre radiométrique (12).

4. Circuit selon la revendication 3, **caractérisé en ce que** le dispositif magnétique (6) est la bobine d'arrêt dont l'enroulement est connecté parmi les bornes (Z1) et (Z2).

5. Circuit selon la revendication 3, **caractérisé en ce que** le dispositif magnétique (6) est le transformateur dont l'enroulement primaire est connecté parmi les bornes (Z1) et (Z2) et l'enroulement secondaire parmi les bornes (Z3) et (Z4).

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4840495 A
- TW 000200828355 A
- CN 000002269589 Y
- PL 187668
- PL 206218
- JP 59108968 B
- JP 59092364 B
- WO 240461 A

**Non-patent literature cited in the description**

- **K.T. SON ; C.C. LEE.** Temperature measurement of high-density winding coils of electromagnets. *IET Science Measurement and Technology,* 2012, vol. 6 (1), 1-5